# EUROPÄISCHE PATENTSCHRIFT

(11) **EP 0 607 179 B1**
(45) Veröffentlichungstag und Bekanntmachung des Hinweises auf die Patenterteilung: **05.12.2001**
(21) Anmeldenummer: 92919577.4
(22) Anmeldetag: 17.09.1992
(51) Int. Cl.: H01L 27/02

(54) **BIPOLARE MONOLITHISCH INTEGRIERTE SCHALTUNG**
DIPOLAR MONOLITHICALLY INTEGRATED CIRCUIT
CIRCUIT INTEGRE MONOLITHIQUE BIPOLAIRE

(30) Priorität: 08.10.1991 DE 4133245
(43) Veröffentlichungstag der Anmeldung: 27.07.1994
(73) Patentinhaber: ROBERT BOSCH GMBH, 70442 Stuttgart (DE)
(72) Erfinder: CONZELMANN, Gerhard, D-7022 Leinfelden-Echterdingen (DE); KAINER, Robert, D-7410 Reutlingen 11 (DE); FIEDLER, Gerhard, D-7441 Neckartailfingen (DE); JOCHEN, Peter, D-7410 Reutligen (DE)
(86) Internationale Anmeldenummer: DE9200791
(87) Internationale Veröffentlichungsnummer: WO9307642

(56) Entgegenhaltungen:
- EP-A- 0 040 125
- EP-A- 0 261 556
- WO-A-90/01801

## Beschreibung

### Stand der Technik

Die Erfindung betrifft eine bipolare monolithisch integrierte Schaltung nach der Gattung des Hauptanspruchs.

Eine derartige Schaltung ist aus der DE-OS 39 24 278 bekannt.

Hierbei ist beispielsweise eine Barriere im Substrat vorgesehen, die die injizierende Quelle ringförmig umschließt und die nach Figur 8a, b der DE-OS 39 24 278 aus einem pnp-Transistor besteht, dessen Kollektorzone selbst die Barriere bildet, dessen Emitter an eine positive Versorgungsspannung angeschlossen ist und dessen Basis vom Minoritätsstrom angesteuert ist. Von Nachteil ist bei dieser Anordnung, daß der Emitterstrom des Barrieren-Transistors bei ringförmigen Barrieren um die Quellen des Minoritätsstroms stets größer sein muß als der injizierte Minoritätsstrom selbst bzw., wenn die Quelle an eine Chipkante gelegt ist, größer als der halbe Minoritätsstrom. Hierdurch ist diese Lösung strommäßig nach oben hin begrenzt.

In der Schaltung nach Figur 9a, b der DE-OS 39 24 278 wird das erforderliche Barrierenpotential dagegen mittels des injizierten Minoritätsstroms selbst erzeugt; somit ist kein zusätzlicher Strom aus der Betriebsstromquelle erforderlich. Diese Lösung würde sich deshalb besonders für große Ströme eignen. Sie versagt jedoch generell, da außerhalb der Barriere kein zwingend notwendiges retardierendes Potential aufgebaut wird. Wegen des unvermeidlichen Nebenschlusses durch den Substratwiderstand versagt jedoch auch diese Lösung bei kleinen Strömen nahezu völlig.

### Vorteile der Erfindung

Die erfindungsgemäße Schaltung mit den kennzeichnenden Merkmalen des Hauptanspruchs hat demgegenüber den Vorteil, daß sie in einem von "Null" ausgehenden, bis zu hohen Strömen reichenden Strombereich anwendbar ist, ohne daß größere Ströme aus der Betriebsstromquelle erforderlich sind. Weitere Vorteile ergeben sich aus den Unteransprüchen 2 bis 6.

### Zeichnung

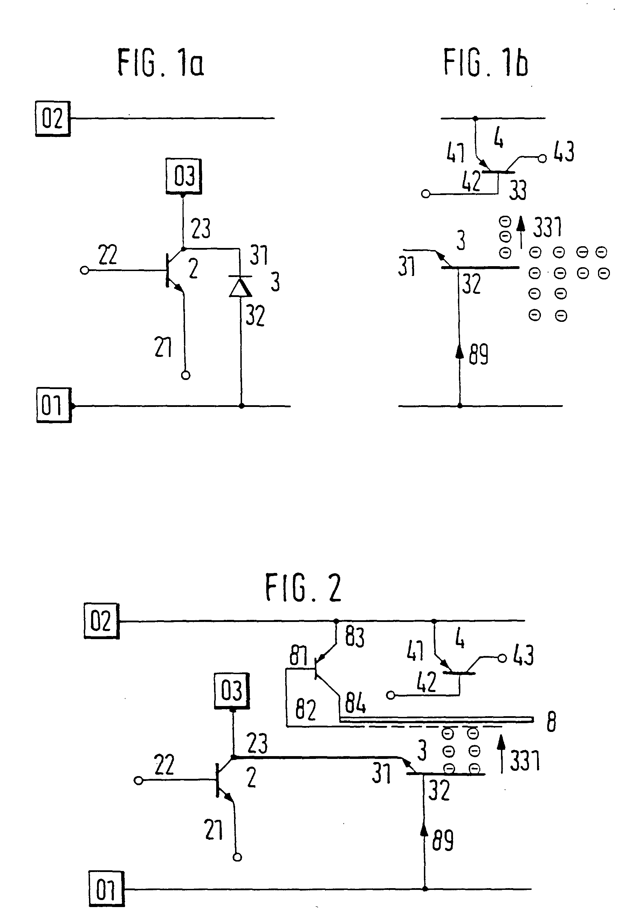

Die Erfindung sei anhand der Figuren 1 bis 5 beispielhaft für eine monolithisch integrierte Schaltung auf der Basis eines p-dotierten Substrats erläutert:

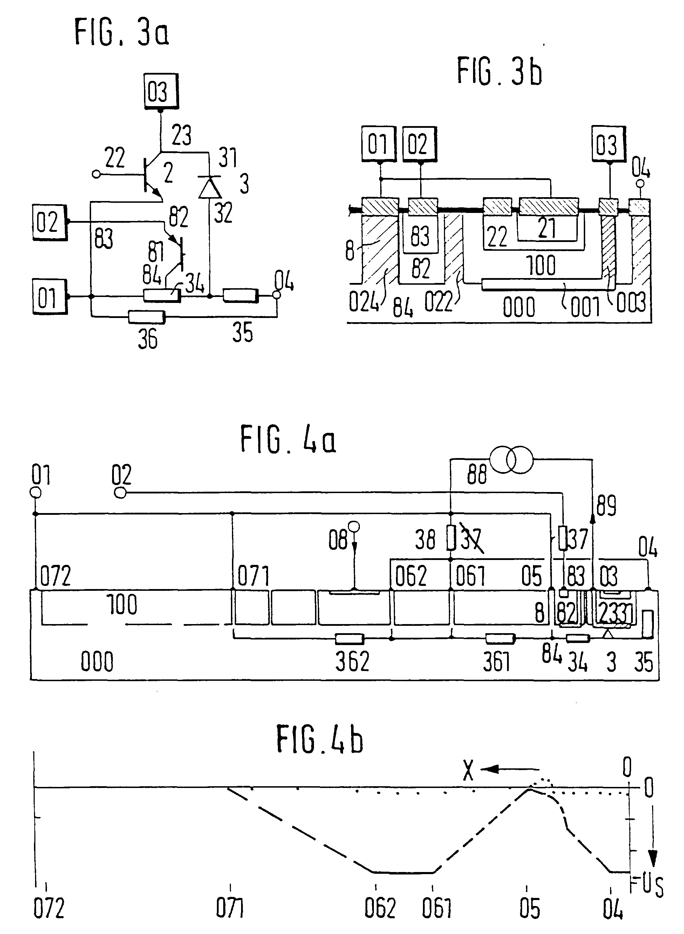

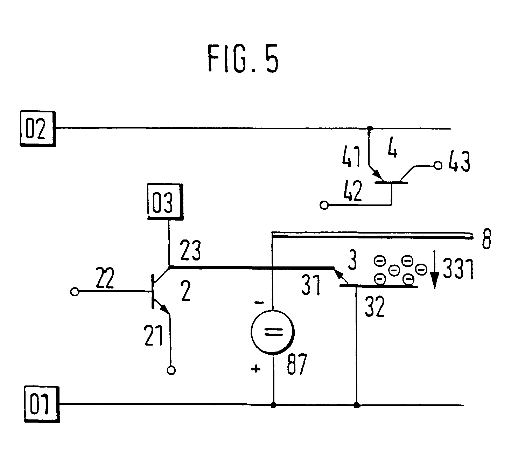

Figur 1a zeigt die Schaltung eines einen Minoritätsstrom erzeugenden, Figur 1b die des den Minoritätsstrom empfangenden Transistors; in Figur 2 ist die aus den Figuren 8a, b der DE-OS 39 24 278 bekannte Barriere mit einem selbststeuernden pnp-Substrattransistor dargestellt. Figur 3a zeigt die Schaltung eines Ausführungsbeispiels der Erfindung, Figur 3b den dazu gehörenden Teil eines Schnitts durch die Struktur eines entsprechenden Chips. Figur 4a gibt den Schnitt durch die Struktur eines ganzen Chips wieder, bei dessen Layout die Lehre der Erfindung angewandt ist, entsprechend zeigt Figur 4b in etwa den Verlauf des Substratpotentials entlang der x-Achse des Chips. In Figur 5 ist das Prinzip einer Barriere zum Unschädlichmachen des Minoritätsstroms durch Totalreflexion wiedergegeben.

### Beschreibung der Erfindung

In Figur 1a ist 01 der eine masseseitige Anschluß, 02 der Anschluß für den anderen (positiven) Pol der Betriebsspannung und 2 ein üblicher npn-Transistor; 21 ist sein Emitter, 22 seine Basis und 23, 31 sein Kollektor, der einerseits mit dem Anschlußfleck 03 verbunden ist; andererseits bildet der Kollektor 31 mit dem Substrat als Anode 32 die parasitäre Diode 3. In Figur 1b ist die Anordnung beispielhaft ergänzt durch einen mehr oder weniger weit entfernt liegenden pnp-Transistor 4 mit seinem Emitter 41, seiner Basis 42 und seinem Kollektor 43. Die Substratdiode 3 ist dargestellt als Transistor mit der Kathode 31 als Emitter, dem räumlich ausgedehnten Substrat 32 als Basis und dem entfernt liegenden Kollektor 33, der identisch ist mit der am positiven Potential liegenden Basis 42 des pnp-Transistors 4; fließt durch die Substratdiode 3 der parasitäre Strom 89, so wird der (von Elektronen gebildete) Minoritätsstrom 331 injiziert, den es gilt, unschädlich zu machen.

Figur 2 zeigt die aus der DE-OS 39 24 278 bekannte Lösung mit dem selbststeuernden pnp-Transistor 81 als Barriere 8, dessen Basis 82 von einem Teil des Minoritätsstroms angesteuert wird und dessen Kollektor 84 die Barriere 8 im Substrat potentialmäßig über Massepotential anhebt. Sind keine anderen Senken für den injizierten Minoritätsstrom vorhanden, so muß dieser Transistor den gesamten Minoritätsstrom aufnehmen.

In Figur 3b, einem Schnitt durch das Chip-Substrat, bedeuten:

| | |
|---|---|
| 000 | Substrat |
| 001 | "buried layer" |
| 0022 | Isolierungsdiffusion |
| 100 | Epitaxie |
| 003 | Kollektoranschluß-Diffusion |

Die Isolierungs-Diffusion 0022 ist weit, die Kollektor-Anschluß-Diffusion 003 eng von links unten nach rechts oben, das strukurierte Metall dagegen von links oben nach rechts unten schraffiert wiedergegeben.

Basis, Emitter und Metall lassen sich leicht erkennen, so daß auf ihre Bezeichnung verzichtet wurde.

In Figur 3a sind wieder 01, 02 die beiden Pole der Betriebsspannung, 2 der npn-Transistor mit seiner parasitären Substratdiode 3 als Quelle für die Minoritäten. Zwischen der Klemme 01 und der Anode 32 der Substratdiode 3 liegt im Substrat ihr widerstandsmodulierter Bahnwiderstand 34; die Barriere 8 und eine Teilstrecke des Widerstands 34 bilden den Kollektor 84 des Barrierentransistors 81. Zwischen dem Verbindungspunkt des Widerstands 34 und der Anode 32 und dem Substratanschluß 04 liegt der Substratwiderstand 35, zwischen den Anschlüssen 04 und 01 der resultierende Substratwiderstand 36, der sich je nach Layout auch aus der Parallelschaltung mehrerer Substratwiderstände bilden kann (in Figur 4a beispielsweise aus den Widerständen 361, 362). Der durch den Widerstand 34 fließende Anteil des parasitären Substratstroms 89 erzeugt dort einen Spannungsabfall; damit wird sein anodenseitiger Punkt negativer als die Klemme 01. Dieses negative Potential ist über den Widerstand 35 am Substratanschluß 04 abgreifbar; wird es von diesem "innenliegenden"

Substratanschluß einem außenliegenden, etwa bei 061, zugeführt, so ist der zwischen 04 und 061 liegende und mit dem einen Pol 01 der Betriebsspannung verbundene Substratanschluß 05 der positivste Punkt. Der den Minoritätsstrom injizierende Strom 89 erzeugt gleichzeitig die hinreichend stromstarke Barriere 8; sie durchlaufende Minoritäten werden in dem zwischen 05 und 061 bestehenden retardierenden Feld auf die Barriere zurückgetrieben und von ihr abgesaugt. Die Widerstände 34 und 35 sind durch die Minoritäten widerstandsmoduliert, d.h., sie nehmen mit zunehmendem Strom 89 ab.

Nachteilig ist, daß jetzt das außerhalb der Barriere 8 liegende Substrat im Takt der periodisch oder sporadisch auftretenden Minoritätsströme abgesenkt und nach ihrem Verschwinden wieder auf Null angehoben wird. Da jedoch einmal aus der Tiefe des Substrats entfernte Minoritäten nicht wieder auftauchen können, darf das Substrat an von den Stellen 06 bzw. 061, 062 hinreichend weit entfernt liegenden Orten 071 wieder mit Masse 01 verbunden werden. Damit ergibt sich schematisiert der in Figur 4b entlang der x-Achse gezeigte Potentialverlauf.

Wie eingangs erwähnt, versagt diese Anordnung wegen des zum Widerstand 34 parallel liegenden resultierenden Substratwiderstands 36 bei kleinen Injektionsströmen. Diese lassen sich nun dadurch entfernen, daß zwischen der Quelle der Minoritäten, Transistor 2 bzw. Diode 3 und der Barriere 8, 05 eine Wanne 82 eingefügt wird, die an die andere (positive) Klemme 02 der Betriebsspannung anzuschließen ist. Vorteilhaft ist, diese Wanne durch einen p-Emitter 83 als pnp-Substrattransistor 81 auszubilden.

Sein Kollektor 84 wird von einem Teilbereich des Substratwiderstands 34 gebildet, seine offene Basis 82 wird vom Minoritätsstrom angesteuert. Der Kollektorstrom dieses Hilfstransistors 81 bewirkt, daß auch bei kleinem Injektionsstrom die Barriere 8 hinreichend positiv angehoben wird (punktierter Potentialverlauf in Figur 4). Bei hohen Injektionsströmen 89 würde der Hilfstransistor 81 unnötig große Ströme ziehen; dies läßt sich dadurch vermeiden, daß der Emitter an eine Stromquelle mit begrenztem Strom oder einfach über einen Widerstand 37 mit dem anderen (positiven) Pol 02 der Betriebsspannungsquelle verbunden ist.

In Sonderfällen kann es bei kleinen Injektionsströmen 89 erforderlich werden, den Hilfstransistor 81 mehr Strom ziehen zu lassen, als seinem influenzierten Basisstrom entspricht. Hierzu ist seiner Basis 82 in bekannter Weise ein Hilfsstrom zuzuführen.

Damit der Minoritätsstrom sicher abgefangen wird, sollte die Barriere die die Minoritätsströme injizierenden bzw. die zu schützenden Komponenten umschließen. Besonders vorteilhaft ist, letztere am Chiprand anzuordnen und die hinreichend breite Barriere 8 von Chiprand zu Chiprand gehen zu lassen. Außerdem ist es vorteilhaft, im Layout unmittelbar anschließend an die Barriere 8 die gegen Minoritätsströme unempfindlicheren Teile der Schaltung anzuordnen, wodurch sich der Aufwand für eine störsichere Schaltung reduzieren läßt.

Der Erfolg dieser Lösung wurde an einer Teststruktur entsprechend Figur 4a gemessen. Die Quelle der Minoritäten ist an den rechten Chiprand linkskantig gelegt, so daß die Minoritäten zu etwa 50% an den Rändern rekombinieren können. Aufgenommen wurde der Minoritätsstrom in den Meßfleck 08. Um die Grenzen des Verfahrens abzutasten, wurde dem vorhandenen Substratwiderstand 361 mit ca 25 Ohm ein Widerstand 36 mit 2,6, mit 5 und mit 10 Ohm (Kennzeichen *) parallelgeschaltet und beim Hilfstransistor 81 Emitterwiderstände 37 mit 120 und 300 Ohm (Kennzeichen #) verwendet. Die Ergebnisse für Injektionsströme I_{E} von 20 bis 2000 mA für aus- und eingeschalteten Substrattransistor 81 sowie die erzielte Dämpfung in dB bezogen auf den Meßstrom ohne Barriere zeigen, daß das Einschalten des Transistors 81 bei kleinen Strömen den Hauptanteil der Dämpfung bringt; bei Strömen oberhalb 600 mA verschwindet seine Wirkung ganz. Bezieht man die Dämpfung auf den Injektionsstrom, so ist sie im ganzen Bereich größer als 120 dB. Durch die Widerstandsmodulation liegen die Widerstände 34, 35 bei einem Injektionsstrom 89 von 2 A im Bereich 1 bis 2 Ohm, bezogen auf das vorgegebene Layout.

Ist der Widerstand 36 bei einem vorgegebenen Layout zu hochohmig, kann er durch Parallelschalten eines äußeren oder eines mit einer oder mehreren Zonen unterschiedlicher Polarität erzeugten integrierten Widerstands 38 reduziert werden.

Eine Alternative, wichtig für das Verständnis der Erfundung, besteht darin, die Barriere hinreichend negativ gegen das Substrat vorzuspannen. Die aus Elektronen bestehenden Minoritäten werden reflektiert, sofern das negative Potential von der Anschlußfläche bis zur entgegengesetzten Hauptfläche des Substrats hindurchgreift; sie rekombinieren im abgesperrten Bereich. Diese Lösung benötigt jedoch zusätzlich eine negative Betriebsstrom- bzw. Betriebsspannungsguelle, deren Strom praktisch unabhängig von injizierten Minoritätsstrom nur durch den zu überwindenden Substratwiderstand gegeben ist. Zu beachten ist allerdings, daß die Minoritäten nicht aus dem Substrat entfernt, sondern nur eingesperrt werden. In dem abgegrenzten Raum besteht eine hohe Minoritätendichte; bereits geringfügige Potentialverschiebungen können die Barriere undicht werden lassen.

## Patentansprüche

1. Bipolare monolithisch integrierte Schaltung mit einem Substrat eines ersten Leitungstyps und Wannen, die mit dem Substrat einen pn-Übergang bilden, wobei mindestens eine Wanne durch Signalspannungen, parasitäre Effekte oder durch auf Zuleitungen eingestrahlte hochfrequente Wechselspannungen zeitweilig gegen das Substrat in Durchlaßrichtung schaltbar ist, so daß ein Minoritätsstrom (331) in das Substrat injiziert wird, der mittels einer Barriere (8) abgefangen wird, welche die als Quelle für den Minoritätsstrom wirkende Wanne (23, 31) umschließt und welche sich von der Oberfläche des substrats mit dem gleichen Leitungstyp wie das Substrat bis in das Substrat hinein erstreckt, wobei die Barriere (8) mit einem Massepol (01) der Betriebsspannung verbunden ist, **dadurch gekennzeichnet, daß** mindestens eine außerhalb der Barriere liegenden Substratzone (061, 062) mit mindestens einer innerhalb der Barriere liegenden Substratzone (04) verdrahtet ist, so daß ein innerhalb der Barriere (8) von dem parasitären Strom (89) erzeugtes Substratpotential mindestens einer außerhalb der Barriere (8) liegenden Substratzone (061, 062) zugeführt wird.

2. Bipolare monolithisch integrierte Schaltung nach Anspruch 1, **dadurch gekennzeichnet, daß** zwischen der Barriere (8) und der als injizierenden Quelle wirkenden Wanne (23, 31) eine Wanne (82) eingefügt ist, die mit einem Pluspol (02) der Betriebsspannung verbunden ist, und die einen pn-Übergang zum Substrat bildet.

3. Bipolare monolithisch integrierte Schaltung nach Anspruch 1, **dadurch gekennzeichnet, daß** zwischen der Barriere (8) und der als injizierenden Quelle wirkenden Wanne (23, 31) eine Wanne (82) eingefügt ist, in der ein Emitter (83) eingebracht ist, daß der Emitter (83) mit einem Pluspol (02) der Betriebsspannung verbunden ist, und daß der Emitter (83) mit der Wanne (82) und einer unter der Wanne (82) liegenden Substratzone (84) und der Barriere (8) einen Substrattransistor (81) bildet.

4. Bipolare monolithisch integrierte Schaltung nach Anspruch 3, **dadurch gekennzeichnet, daß** Mittel zur Begrenzung des Emitterstrom des Substrattransistors (81) vorgesehen sind.

5. Bipolare monolithisch integrierte Schaltung nach Anspruch 4, **dadurch gekennzeichnet, daß** die Mittel zur Begrenzung des Emitterstroms durch den Substrattransistor (81) durch einen Widerstand (37) gebildet wird.

6. Bipolare monolithisch integrierte Schaltung nach Anspruch 4, **dadurch gekennzeichnet, daß** Mittel vorgesehen sind, die der Basis (82) des Substrattransistors (81) einen Hilfsstrom zuführen.

## Claims

1. Bipolar monolithically integrated circuit comprising a substrate of a first conduction type and wells which, together with the substrate, form a pn junction, in which at least one well can be temporarily switched in the forward direction with respect to the substrate by means of signal voltages, parasitic effects or by high-frequency alternating voltages irradiated on feed lines so that a minority current (331) is injected into the substrate, which is intercepted by means of a barrier (8) which encloses the well (23, 31) acting as a source for the minority current and which extends from the surface of the substrate with the same conduction type as the substrate into the substrate, the barrier (8) being connected to an earth pole (01) of the operating voltage, **characterized in that** at least one substrate zone (061, 062) lying outside the barrier is wired to at least one substrate zone (04) lying inside the barrier so that a substrate potential generated by the parasitic current (89) inside the barrier (8) is supplied to at least one substrate zone (061, 062) lying outside the barrier (8).

2. Bipolar monolithically integrated circuit according to Claim 1, **characterized in that** between the barrier (8) and the well (23, 31) acting as injecting source, a well (82) is inserted which is connected to a positive pole (02) of the operating voltage and which forms a pn junction to the substrate.

3. Bipolar monolithically integrated circuit according to Claim 1, **characterized in that** between the barrier (8) and the well (23, 31) acting as injecting source, a well (82) is inserted in which an emitter (83) is inserted, that the emitter (83) is connected to a positive pole (02) of the operating voltage and that the emitter (83), together with the well (82) and a substrate zone (84) lying under the well (82), and the barrier (8) forms a substrate transistor (81).

4. Bipolar monolithically integrated circuit according to Claim 3, **characterized in that** means for limiting the emitter current of the substrate transistor (81) are provided.

5. Bipolar monolithically integrated circuit according to Claim 4, **characterized in that** the means for limiting the emitter current through the substrate transistor (81) is formed by a resistor (37).

6. Bipolar monolithically integrated circuit according to Claim 4, **characterized in that** means are provided which supply an auxiliary current to the base (82) of the substrate transistor (81).

## Revendications

1. Circuit intégré monolithique bipolaire comprenant un substrat d'un premier type de conductivité et des cuvettes formant une jonction pn avec le substrat,
au moins une cuvette étant commutée de temps en temps dans le sens passant par rapport au substrat, par des tensions de signaux, par des effets parasites ou par l'injection d'une tension alternative de haute fréquence, de sorte qu'un courant minoritaire (331) est injecté dans le substrat, ce courant étant reçu par une barrière (8) entourant la cuvette (23, 31) fonctionnant comme source de courant minoritaire et qui s'étend depuis la surface du substrat, avec le même type de conductivité que le substrat, jusque dans le substrat,
la barrière (8) étant reliée à la masse (01) de la tension de fonctionnement,
**caractérisé en ce qu'**
au moins une zone de substrat (061, 062) située en dehors de la barrière est reliée à au moins une zone de substrat (04) située à l'intérieur de la barrière, de façon qu'un potentiel de substrat généré à l'intérieur de la barrière (8) par le courant parasitaire (89), soit fourni à au moins une zone de substrat (061, 062) située à l'extérieur de la barrière (8).

2. Circuit intégré monolithique bipolaire selon la revendication 1,
**caractérisé en ce qu'**
entre la barrière (8) et la cuvette (23, 31) fonctionnant comme source d'injection, une cuvette (82) est reliée au pôle positif (02) de la tension de fonctionnement et forme une jonction pn avec le substrat.

3. Circuit intégré monolithique bipolaire selon la revendication 1,
**caractérisé en ce qu'**
entre la barrière (8) et la cuvette (23, 31) fonctionnant comme source d'injection, on a une cuvette (82) avec un émetteur (83),
l'émetteur (83) est relié au pôle plus (02) de la tension de fonctionnement, et
l'émetteur (83) forme un transistor de substrat (81) avec la cuvette (82) et une zone de substrat (84) située sous la cuvette (82) et la barrière (8).

4. Circuit intégré monolithique bipolaire selon la revendication 3,
**caractérisé**
**par** des moyens pour limiter le courant d'émetteur du transistor de substrat (81).

5. Circuit intégré monolithique bipolaire selon la revendication 4,
**caractérisé en ce que**
les moyens pour limiter le courant d'émetteur à travers le transistor de substrat (81) sont formés par une résistance (37).

6. Circuit intégré monolithique selon la revendication 4,
**caractérisé**
**par** des moyens qui fournissent un courant auxiliaire à la base (82) du transistor de substrat (81).
